# FASCICULE DE BREVET EUROPEEN

(11) **EP 3 449 514 B1**
(45) Date de publication et mention de la délivrance du brevet: **13.05.2020**
(21) Numéro de dépôt: 17719250.7
(22) Date de dépôt: 25.04.2017
(51) Int. Cl.: H01L 33/06, H01L 33/12, H01L 33/32, H01L 33/14

(54) **DIODE ÉLECTROLUMINESCENTE À BASE DE NITRURES DU GROUPE III**
GRUPPE III NITRID-BASIERTE LEUCHTDIODE
GROUP III NITRIDE-BASED LIGHT-EMITTING DIODE

(30) Priorité: 27.04.2016 FR 1653738
(43) Date de publication de la demande: 06.03.2019
(73) Titulaire: Commissariat à l'énergie atomique et aux énergies alternatives, 75015 Paris (FR)
(72) Inventeur: EVEN, Armelle, 38000 GRENOBLE (FR); ELOUNEG-JAMROZ, Miryam, 38000 GRENOBLE (FR); ROBIN, Ivan-Christophe, 38000 GRENOBLE (FR)
(74) Mandataire: Brevalex
(86) Numéro de dépôt international: PCT/EP2017/059711
(87) Numéro de publication internationale: WO 2017/186666

(56) Documents cités:
- WO-A1-2005/076374
- WO-A1-2014/154690
- WO-A1-2015/008871
- WO-A1-2015/059296
- US-A1- 2009 152 586
- US-A1- 2009 278 113
- US-A1- 2011 204 394
- US-A1- 2013 187 168
- US-A1- 2014 264 408

## Description

### DOMAINE TECHNIQUE ET ART ANTÉRIEUR

L'invention concerne le domaine des diodes électroluminescentes (appelées DELs ou LEDs) comprenant un ou plusieurs puits quantiques.

Dans la technique actuelle de fabrication des LEDs à partir de semi-conducteurs GaN / InGaN en couches minces, chaque LED comporte une zone active constituée de plusieurs puits quantiques formés de couches émissives d'InGaN chacune disposée entre deux couches barrières de GaN. Cette zone active est disposée dans la zone de déplétion d'une jonction p-n formée par deux couches de GaN, l'une dopée n et l'autre dopée p. Les semi-conducteurs de la zone active, c'est-à-dire ceux formant les couches émissives et les couches barrières, ont un dopage intrinsèque, c'est-à-dire ne sont pas dopés intentionnellement (mais comporte une concentration de donneurs résiduels n_{nid} de l'ordre de 10¹⁷ donneurs/cm³). Lorsqu'une tension de polarisation directe (« forward biasing » en langue anglaise) est appliquée aux bornes de la jonction p-n, un courant pénètre dans la jonction p-n et les porteurs de charges (électrons et trous) peuvent se recombiner de manière radiative dans la zone de déplétion de la jonction p-n. Les porteurs de charge se localisent préférentiellement dans les couches émissives, ce qui augmente de plusieurs ordres de grandeur le taux de recombinaisons radiatives dans la zone de déplétion par rapport à une simple jonction p-n ne comportant pas de puits quantique. La zone active comporte typiquement entre trois et six puits quantiques. Les couches émissives ont chacune une épaisseur qui varie par exemple entre 1 nm et 5 nm, et l'InGaN de ces couches émissives comporte une concentration d'indium par exemple comprise entre 5 % et 40 %.

Une LED telle que décrite ci-dessus a une efficacité de conversion du courant en lumière, également appelée efficacité radiative ou encore rendement quantique interne (ou IQE pour « Internai Quantum Efficiency » en langue anglaise), qui est maximale lorsque la LED est soumise à une faible densité de courant, de l'ordre de 10 A/cm². À des densités de courant plus élevées, l'efficacité radiative de la LED chute rapidement, ce qui limite donc l'efficacité d'une telle LED utilisée avec une forte puissance de fonctionnement. Ce phénomène est appelé « LED droop ».

Un des facteurs limitant l'efficacité radiative dans les LEDs est le faible courant de trous capable de traverser la jonction p-n, à cause de la faible mobilité des trous. En effet, la grande majorité des trous ont tendance à s'accumuler dans la couche émissive se trouvant du côté de la couche de GaN dopé p de la jonction p-n, et c'est donc dans cette couche émissive que la majorité des recombinaisons radiatives se produisent.

Afin d'augmenter ce courant de trous, les couches barrières en GaN peuvent être remplacées par des couches barrières en InGaN. Le document WO 2014/154690 A1 propose également, pour faciliter la circulation des trous dans la zone active de la LED, de réaliser une jonction p-n asymétrique comprenant une couche tampon d'InGaN interposée entre la couche de GaN dopé n et la zone active. Ces solutions permettent d'obtenir une circulation d'un plus fort courant de trous à travers la jonction p-n et une meilleure répartition des trous dans les différentes couches émissives de la zone active, tout en formant une barrière plus élevée pour les électrons afin d'en limiter le débordement, ou « l'overflow ». Comparativement à une structure comprenant des couches barrières en GaN, la baisse de la contrainte du réseau entre des couches barrières en In_{y}Ga_{1-y}N et des couches émissives en In_{X}Ga_{1-X}N, où X > Y, réduit aussi le champ électrique dans les couches émissives et améliore de ce fait le rendement radiatif en augmentant le recouvrement des fonctions d'ondes entre les électrons et les trous.

La réalisation d'une zone active comprenant des couches émissives et des couches barrières en InGaN nécessite la mise en œuvre d'une croissance épitaxiale d'une couche d'InGaN épaisse de plusieurs dizaines de nanomètres. Or, la qualité cristalline d'une telle couche épaisse d'InGaN synthétisée sur une couche de GaN est limitée, et cela d'autant plus que la proportion d'indium dans l'InGaN est importante. Cela est dû à la différence importante (^{∼} 11 %) du paramètre de maille entre le GaN et l'InN. Durant la croissance du cristal d'InGaN, la forte contrainte engendrée dans le cristal cause l'apparition de défauts de type trou en forme de V, ou « V-pit », et d'inhomogénéités spatiales d'indium allant jusqu'à la ségrégation de phases d'indium métalliques. Ces défauts créent également une rugosité de surface de croissance qui peut atteindre plusieurs nanomètres, ce qui peut affecter considérablement la croissance de puits quantiques d'épaisseurs homogènes et de bonne qualité cristalline. Plus le taux d'indium dans l'InGaN est élevé, et plus les défauts dus à la contrainte sont fréquents. Une forte densité de défauts entraîne une forte densité de centres de recombinaisons non-radiatifs, et donc une baisse de la qualité optique du matériau obtenu se répercutant sur l'efficacité radiative de la LED. De plus, des défauts sont également inhérents à la croissance de l'InGaN même quand celui-ci n'est pas contraint.

Dans ce contexte, diverses LEDs à base de nitrures du groupe III sont connues de, par exemple: US 2009/0278113 A1, US 2013/0187168 A1, WO 2015/008871 A1, US 2009/0152586 A1, WO 2005/076374 A1, ou encore US 2011/0204394 A1.

### EXPOSÉ DE L'INVENTION

L'invention concerne une diode électroluminescente selon la présente revendication 1.

Des modes de réalisation avantageux de cette diode électroluminescente sont l'objet des présentes revendications dépendantes.

Un but de la présente invention est de proposer une solution pour augmenter l'efficacité radiative d'une diode électroluminescente comprenant au moins un puits quantique formé d'une couche émissive d'InGaN et de couches barrières d'InGaN quelle que soit la densité de courant avec laquelle la diode est utilisée, tout en préservant la qualité du cristal en évitant l'apparition de défauts lors de la réalisation de la zone active de la diode.

Pour cela, l'invention propose une diode électroluminescente selon la revendication 1 et comprenant au moins :
- une première couche comprenant du semi-conducteur dopé n et une deuxième couche comprenant du semi-conducteur dopé p, les première et deuxième couches formant une jonction p-n ;
- une zone active disposée entre les première et deuxième couches, comprenant au moins une couche émissive comportant de l'In_{X}Ga_{1-X}N et apte à former un puits quantique, et au moins deux couches barrières comportant de l'In_{Y}Ga_{1-Y}N et entre lesquelles la couche émissive est disposée, et avec X et Y nombres réels tels que 0 < Y < X ;
- une couche intermédiaire, disposée dans la couche barrière se trouvant entre la couche émissive et la première couche telle que des parties de ladite couche barrière soient disposées de part et d'autre de la couche intermédiaire, ou disposée entre ladite couche barrière et la couche émissive, la couche intermédiaire comportant un semi-conducteur de type III-N dont le gap est supérieur à celui du semi-conducteur de ladite couche barrière.

Ainsi, une ou plusieurs couches intermédiaires sont disposées au sein d'une ou plusieurs des couches barrières, ou contre une ou plusieurs des couches barrières, de la zone active de la LED. Les couches barrières et les couches émissives comportent de l'InGaN. Cette ou ces couches intermédiaires comportent un matériau de gap supérieur à celui du matériau de la ou des couches barrières. Cette ou ces couches intermédiaires permettent, lors de la réalisation de la zone active, d'obtenir un cristal d'InGaN de meilleure qualité optique et de réduire la rugosité de la surface de croissance de l'InGaN, et cela d'autant plus que le taux d'indium, ou la concentration en indium, dans l'InGaN de la zone active est important. La présence de cette ou ces couches intermédiaires est donc particulièrement intéressante pour une LED destinée à émettre de la lumière dans la gamme des longueurs d'ondes correspondant à la couleur verte et/ou rouge du fait qu'une telle LED est réalisée à partir d'InGaN ayant un fort taux d'indium, typiquement compris entre environ 20 % et 45 %.

En utilisant cette ou ces couches intermédiaires (dont le matériau présente un gap plus important que celui des matériaux de la ou des couches émissives et des couches barrières) dans une zone active comportant de l'InGaN, l'homme du métier pourrait s'attendre à ce que la circulation des charges soit bloquée ou réduite du fait de l'utilisation d'un matériau de plus grand gap dans la zone active. Mais, de manière contre-intuitive, de telles couches intermédiaires positionnées au sein des couches barrières entre les couches émissives (ou uniquement entre la couche émissive et la première couche lorsque la LED comporte une seule couche émissive) ont pour effet de modifier la répartition des charges dans les puits quantiques mais en favorisant les recombinaisons radiatives dans les couches émissives, du fait que les trous circulent mieux dans la zone active grâce aux couches barrières en InGaN et que les couches intermédiaires ont pour effet d'augmenter la quantité de trous dans le ou les puits quantiques se trouvant du côté de la deuxième couche de semi-conducteur dopé p. Cela engendre donc un meilleur équilibre du nombre d'électrons et de trous dans le ou les puits quantiques du côté de la deuxième couche de semi-conducteur dopé p, ce qui se traduit par un plus grand nombre de recombinaisons radiatives dans ce ou ces puits quantiques. Une augmentation relative des recombinaisons radiatives est d'autant plus importante que la fraction d'InN dans l'InGaN de la zone active est importante (une augmentation de la fraction d'InN augmente le nombre de recombinaisons non-radiatives du fait d'une grande densité de défauts cristallins). Ainsi, l'augmentation des pertes non-radiatives est mieux contrebalancée avec un meilleur équilibre des charges.

Cette ou ces couches intermédiaires permettent donc d'augmenter l'efficacité radiative de la LED par rapport à une LED de structure similaire mais qui ne comporterait pas cette ou ces couches intermédiaires.

Un semi-conducteur de type III-N correspond à un semi-conducteur comportant l'élément azote et un ou plusieurs éléments du groupe 13 du tableau périodique des éléments, par exemple de l'InGaN, de l'AIGaN, de l'AlInGaN ou du BGaN.

Selon l'invention :
- la deuxième couche comporte du GaN et la première couche comporte de l'In_{V}Ga_{1-V}N, avec V nombre réel tel que 0 < V, ou
- la deuxième couche comporte de l'In_{W}Ga_{1-W}N et la première couche comporte de l'In_{V}Ga_{1-V}N, avec V et W nombres réels tels que 0 < W < Y et 0 < W < V.

Puisque, selon l'invention, la première couche comporte de l'InGaN, la contrainte au sein de la zone active, qui comporte également de l'InGaN, est relaxée par rapport à une zone active formée sur une couche de GaN-n. Cette relaxation de la contrainte permet, selon la présente invention, de réaliser les couches de la zone active avec des concentrations d'indium plus importantes, par exemple supérieures à environ 20 % ou supérieures à environ 25 %.

De plus, la qualité cristalline de l'InGaN dépend de sa température de croissance. Ainsi, en comparant une première zone active réalisée à partir d'une couche de GaN et une deuxième zone active réalisée à partir d'une couche d'InGaN, pour une même concentration d'indium dans les première et deuxième zones actives, la température de mise en œuvre de la croissance peut être plus importante lorsque cette croissance est réalisée à partir d'une couche d'InGaN. La qualité cristalline obtenue lors de la réalisation de la deuxième zone active est supérieure à celle obtenue lors de la réalisation de la première zone active.

La diode électroluminescente peut comporter, en outre, un substrat de croissance comportant de l'InGaN sur lequel la première couche est disposée, la première couche comportant, selon l'invention, de l'In_{V}Ga_{1-V}N, avec 0 < V, et la deuxième couche pouvant comporter de l'In_{W}Ga_{1-W}N, avec 0 < W < V. Un tel substrat de croissance en InGaN permet d'améliorer encore la relaxation de la contrainte pour les couches d'InGaN réalisées sur ce substrat de croissance, et donc d'atteindre, au sein de la diode électroluminescente, des concentrations d'indium encore plus importantes, par exemple supérieures ou égales à environ 30 %.

Une configuration particulièrement avantageuse correspond au cas où la diode électroluminescente comporte un tel substrat de croissance comprenant de l'InGaN ainsi qu'une première couche dopée, une zone active et une couche intermédiaire comprenant également de l'InGaN. Dans ce cas, de l'InGaN ayant une concentration d'indium très importante peut être obtenue. Dans une telle structure formée entièrement d'InGaN, de nombreux défauts de type V-pits ont tendance à apparaitre. Toutefois, grâce aux couches intermédiaires utilisées, ces défauts ne se retrouvent pas dans la structure obtenue.

Le semi-conducteur de la couche intermédiaire peut comporter de l'Al_{U}In_{Z}Ga_{1-U-Z}N, avec U et Z nombres réels tels que 0 ≤ U + Z ≤ 1 et 0 ≤ Z < Y, ou peut comporter du BGaN.

Lorsque le semi-conducteur de la couche intermédiaire comporte de l'Al_{U}In_{Z}Ga_{1-U-Z}N, les concentrations en indium Z et Y dans les semi-conducteurs de la couche intermédiaire et de la couche barrière dans laquelle la couche intermédiaire est disposée peuvent être telles que Z ≤ 0,8^{∗}Y.

L'épaisseur de la couche intermédiaire peut être comprise entre environ 0,25 nm (1 monocouche) et 10 nm, et par exemple entre environ 1 nm et 5 nm.

Lorsque le semi-conducteur de la couche intermédiaire comporte de l'Al_{U}In_{Z}Ga_{1-U-Z}N, la concentration en indium Z dans le semi-conducteur de la couche intermédiaire peut varier entre une première valeur minimale Z₁ et une deuxième valeur maximale Z₂ supérieure à Z₁ selon une direction sensiblement perpendiculaire à des faces de la couche intermédiaire en contact avec la couche barrière dans laquelle est disposée la couche intermédiaire, c'est-à-dire le long de l'épaisseur de la couche intermédiaire, et telle que 0 ≤ Z₁ < Z₂ < Y. Cette variation de la concentration en indium Z peut être monotone.

La concentration en indium Y dans le semi-conducteur de la couche barrière dans laquelle la couche intermédiaire est disposée peut varier entre une première valeur minimale Y₁ et une deuxième valeur maximale Y₂ supérieure à Y₁ selon une direction sensiblement perpendiculaire aux faces de la couche barrière en contact avec la couche intermédiaire, c'est-à-dire le long de l'épaisseur de la couche barrière, et telle que 0 ≤ Y₁ < Y₂ < X. La direction de la variation allant de la valeur Y₁ à la valeur Y₂ peut correspondre à la direction allant de la première couche à la deuxième couche, ou bien celle allant de la deuxième couche à la première couche. Cette variation de la concentration en indium Y peut être monotone.

La diode électroluminescente peut être telle que :
- la zone active comporte plusieurs couches émissives comprenant de l'InGaN et chacune apte à former un puits quantique, et plusieurs couches barrières comprenant de l'InGaN et telles que chaque couche émissive soit disposée entre deux couches barrières qui sont en contact avec ladite couche émissive au niveau de deux faces opposées de ladite couche émissive,
- la couche intermédiaire est disposée dans l'une des couches barrières se trouvant entre l'une des couches émissives et la première couche telle que des parties de ladite une des couches barrières soient disposées de part et d'autre de la couche intermédiaire, ou disposée entre ladite une des couches barrières et ladite une des couches émissives,
- le gap du semi-conducteur de la couche intermédiaire est supérieur à celui du semi-conducteur des couches barrières et les concentrations en indium dans l'InGaN des couches émissives sont supérieures à celles dans l'InGaN des couches barrières.

Dans la configuration exposée ci-dessus, la couche intermédiaire peut être disposée au sein de n'importe laquelle des couches barrières sauf celle se trouvant au plus près de la deuxième couche de semi-conducteur dopé p.

La diode électroluminescente peut également comporter plusieurs couches intermédiaires telles qu'une ou plusieurs desdites couches intermédiaires soient disposées dans une ou plusieurs des couches barrières se trouvant entre l'une des couches émissives et la première couche, des parties de ladite une ou plusieurs des couches barrières étant disposées de part et d'autre de chacune des couches intermédiaires. Là encore, les couches intermédiaires peuvent être disposées au sein de n'importe lesquelles des couches barrières sauf celle se trouvant au plus près de la deuxième couche de semi-conducteur dopé p.

Les concentrations en indium dans l'InGaN des couches émissives peuvent être sensiblement égales les unes par rapport aux autres. Cette configuration correspond à une LED monochromatique à plusieurs puits quantiques, pour laquelle l'amélioration de l'efficacité radiative apportée par les couches intermédiaires est particulièrement importante.

La diode électroluminescente peut comporter en outre une couche tampon de semi-conducteur dopé n disposée entre la première couche et la zone active, ledit semi-conducteur dopé n de la couche tampon pouvant comporter une énergie de bande interdite inférieure ou égale à 97 % de l'énergie de bande interdite du semi-conducteur dopé p de la deuxième couche.

La diode électroluminescente peut comporter en outre une couche de blocage d'électrons comprenant au moins un semi-conducteur dopé p de type III-N de gap supérieur à celui du semi-conducteur de la deuxième couche et disposée entre la deuxième couche et la zone active.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une diode électroluminescente, objet de la présente invention, selon un mode de réalisation particulier ;
- la figure 2 représente le diagramme de bandes d'énergie au sein d'une diode électroluminescente à multiples puits quantiques de l'art antérieur ;
- la figure 3 représente le diagramme de bandes d'énergie au sein de la diode électroluminescente, objet de la présente invention, selon le mode de réalisation particulier de la figure 1 ;
- la figure 4 représente la valeur de l'efficacité quantique interne obtenue dans une LED, objet de la présente invention, selon le mode de réalisation particulier de la figure 1 ainsi que dans une LED à multiples puits quantiques de l'art antérieur, en fonction de la densité de courtant, et pour deux valeurs de la durée de vie Shockley-Read-Hall des porteurs minoritaires ;
- la figure 5 représente le taux de recombinaison radiatives obtenu dans la troisième couche émissive d'une LED, objet de la présente invention, selon le mode de réalisation particulier de la figure 1, et d'une LED à multiple puits quantiques de l'art antérieur ;
- la figure 6 représente les concentrations d'électrons et de trous obtenues dans la troisième couche émissive d'une LED, objet de la présente invention, selon le mode de réalisation particulier de la figure 1, et d'une LED à multiple puits quantiques de l'art antérieur, en fonction de la densité de courant.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles dans le cadre de l'invention telle que définie par les présentes revendications.

### EXPOSÉ DÉTAILLÉ DE MODES DE RÉALISATION PARTICULIERS

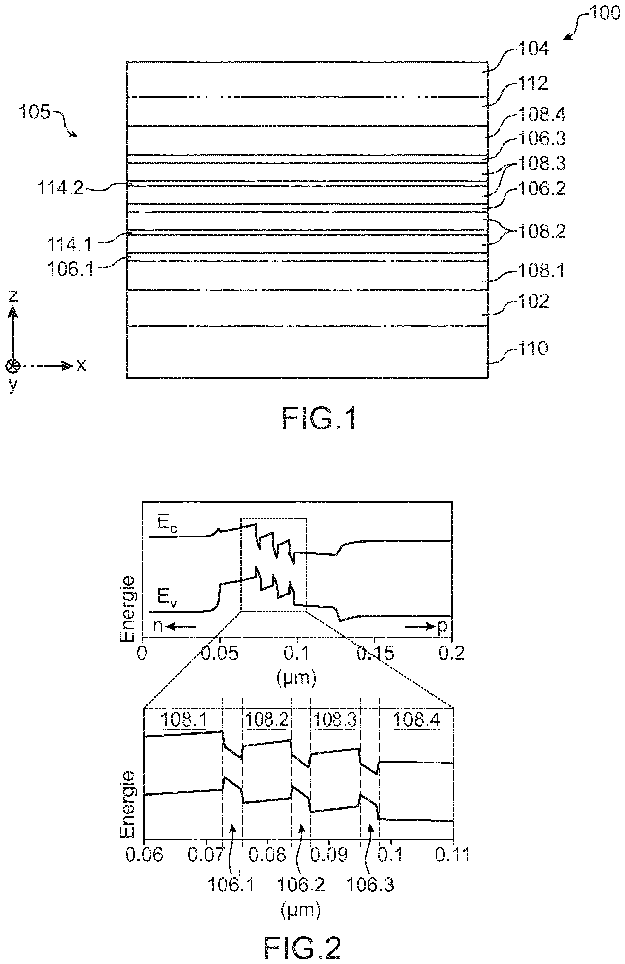

On se réfère tout d'abord à la figure 1 qui représente une diode électroluminescente, ou LED, 100 selon un mode de réalisation particulier de la présente invention.

Dans la notation In_{X}Ga_{1-X}N utilisée, X représente la composition en indium, ou concentration en indium, du matériau, c'est-à-dire la proportion d'indium par rapport à la quantité totale d'indium et de gallium dans l'In_{X}Ga_{1-X}N. Une notation analogue est utilisée pour les compositions d'aluminium et d'indium dans de l'Al_{U}In_{Z}Ga_{1-U-Z}N.

Dans le mode de réalisation particulier décrit ici, la LED 100 comporte une jonction p-n formée par une première couche 102 comprenant de l'InGaN dopé n (InGaN-n) avec une concentration de donneurs par exemple égale à environ 10¹⁹ donneurs/cm³ et une deuxième couche 104 comprenant du GaN dopé p (GaN-p) avec une concentration d'accepteurs par exemple égale à environ 10¹⁹ accepteurs/cm³. Ces deux couches 102 et 104 ont par exemple chacune une épaisseur (dimension selon l'axe Z représenté sur la figure 1) comprise entre environ 20 nm et 10 µm. De manière générale, la première couche 102 peut avoir une concentration de donneurs comprise entre environ 10¹⁷ et 10²⁰ donneurs/cm³, et la deuxième couche 104 peut avoir une concentration d'accepteurs comprise entre environ 10¹⁵ et 10²⁰ accepteurs/cm³.

Dans le cas, ne faisant pas partie de la présente invention telle que définie par les revendications, où la première couche 102 comporterait du GaN dopé n (GaN-n), cette configuration serait moins avantageuse que celle avec la première couche 102 selon l'invention, comportant de l'InGaN-n. À noter que dans le cas ne faisant pas partie de la présente invention, où la première couche 102 comporterait du GaN, alors la deuxième couche 104 peut également comporter du GaN. Selon l'invention, la concentration d'indium V dans l'In_{V}Ga_{1-V}N de la première couche 102 est comprise entre : strictement supérieure à 0 % (excluant donc le cas (d'une première couche 102 comprenant du GaN) et, par exemple, environ 20 %.

En outre, puisque la concentration en indium V dans l'In_{V}Ga_{1-V}N de la première couche 102 est non nulle, la deuxième couche 104 peut comporter de l'In_{W}Ga_{1-W}N avec W > 0. Dans ce cas, la concentration en indium W dans l'In_{W}Ga_{1-W}N de la deuxième couche 104 est inférieure à la concentration en indium V dans l'In_{V}Ga_{1-V}N de la première couche 102, et comprise entre : strictement supérieure à 0 % et, par exemple, 15 %.

La LED 100 comporte, entre les couches 102 et 104, une zone active 105 formée de semi-conducteur intrinsèque comprenant plusieurs couches émissives 106. La LED 100 décrite ici comporte trois couches émissives 106, référencées 106.1, 106.2 et 106.3. De manière générale, la LED 100 peut comporter n couches émissives 106, avec n nombre entier tel que n ≥ 1, et avantageusement tel que 3 ≤ n ≤ 6. Les couches émissives 106 comportent par exemple de l'In_{0,3}Ga_{0,7}N (c'est-à-dire comprenant une proportion de 30 % d'indium pour 70 % de gallium) non intentionnellement dopé (de concentration en donneurs résiduels par exemple telle que n_{nid} = 10¹⁷ donneurs/cm³), d'épaisseur par exemple égale à environ 3 nm.

Le taux d'indium de l'InGaN des couches émissives 106 peut être différent d'une couche à l'autre, la LED 100 étant dans ce cas apte à émettre selon des longueurs d'ondes différentes d'une couche émissive 106 à l'autre. Mais de manière avantageuse, les concentrations en indium dans l'InGaN des couches émissives 106 sont similaires d'une couche émissive à l'autre, la LED 100 correspondant dans ce cas à une LED monochromatique. Dans tous les cas, la valeur de la concentration en indium au sein de la ou des couches émissives 106 est choisie en fonction de la ou des longueurs d'ondes destinées à être émises, et par exemple comprise entre environ 5 % et 40 %.

La zone active 105 de la LED 100 comporte également des couches barrières 108 (au nombre de quatre dans la LED 100 représentée sur la figure 1, et référencées 108.1, 108.2, 108.3 et 108.4) comprenant par exemple de l'In_{0,12}Ga_{0,88}N (comprenant une proportion de 12 % d'indium pour 88 % de gallium) non intentionnellement dopé (de concentration en donneurs résiduels par exemple telle que n_{nid} = 10¹⁷ donneurs/cm³), d'épaisseur par exemple égale à environ 8 nm. Deux des quatre couches barrières 108 sont interposées chacune entre deux couches émissives 106 consécutives, et les deux autres couches barrières 108 sont chacune interposée entre une des couches émissives 106 et l'une des couches 102 et 104. Ainsi, la première couche barrière 108.1 est disposée entre la première couche 102 et la première couche émissive 106.1. La deuxième couche barrière 108.2 est disposée entre la première couche émissive 106.1 et la deuxième couche émissive 106.2. La troisième couche barrière 108.3 est disposée entre la deuxième couche émissive 106.2 et la troisième couche émissive 106.3. La quatrième couche barrière 108.4 est disposée entre la troisième couche émissive 106.3 et la deuxième couche 104. Chaque couche émissive 106 et les deux couches barrières 108 entre lesquelles se trouve cette couche émissive 106 forment un puits quantique.

Les valeurs des concentrations en indium du semi-conducteur des couches barrières 108 sont inférieures à celles du semi-conducteur des couches émissives 106 et donc par exemple comprises entre environ 1 % et 20 %.

De manière générale, la LED 100 qui comporte n couches émissives 106, avec n nombre entier supérieur ou égal à 1, comporte donc n+1 couches barrières 108. La zone active 105 est formée de l'empilement alterné des n couches émissives 106 et des n+1 couches barrières 108. Les couches 106 et 108 peuvent avoir des concentrations en donneurs résiduels comprises entre environ 10¹⁶ et 10²⁰ donneurs/cm³.

Les couches de la zone active 105 sont réalisées par épitaxie, par exemple MOCVD, sur une couche épaisse 110 de GaN formant le substrat de croissance. La structure ainsi formée par ces couches est donc complètement contrainte sur la couche 110 de GaN.

En variante, la couche 110, ou substrat de croissance 110, peut comporter de l'InGaN. Dans ce cas, la LED 100 peut avantageusement correspondre à une structure entièrement formée d'InGaN, c'est-à-dire dont les couches 110, 102, 108, 106, 104 et 114 comportent de l'InGaN. Il est également très avantageux d'avoir une LED 100 comprenant un substrat de croissance 110 comprenant de l'InGaN, et les couches 102, 108, 106 et 114 comprenant de l'InGaN.

Dans le mode de réalisation particulier décrit ici en liaison avec la figure 1, la LED 100 comporte également une couche de blocage d'électrons 112, comportant par exemple de l'AIGaN et disposée entre la dernière couche barrière (correspondant à la couche barrière 108 la plus proche de la deuxième couche 104 dopée p, c'est-à-dire la couche 108.4 dans l'exemple représenté sur la figure 1) et la deuxième couche 104. Une telle couche de blocage d'électrons 112 permet d'empêcher le passage des électrons vers la deuxième couche 104 dopée p. Une telle couche de blocage d'électrons 112 permet également de diminuer le phénomène de « LED droop », c'est-à-dire la chute de l'efficacité quantique interne de la LED 100 lorsque la densité de courant dans la LED 100 augmente, cette chute étant partiellement due à l'échappement des électrons de la zone active 105 quand le courant augmente.

Lorsque la deuxième couche 104 comporte de l'InGaN avec une concentration en indium non nulle, la couche de blocage d'électrons 112 peut comporter du GaN.

De manière générale, la couche de blocage d'électrons 112 comprend au moins un semi-conducteur dopé p de type III-N dont le gap est supérieur à celui du semi-conducteur de la deuxième couche 104.

En variante, la LED 100 peut ne pas comporter la couche de blocage d'électrons 112, la dernière couche barrière 108.4 étant alors disposée contre la deuxième couche 104 dopée p.

La LED 100 comporte également des couches intermédiaires 114 disposées au sein de certaines des couches barrières 108. Dans l'exemple de réalisation de la LED 100 représentée sur la figure 1, une première couche intermédiaire 114.1 est disposée au sein de la deuxième couche barrière 108.2 et une deuxième couche intermédiaire 114.2 est disposée au sein de la troisième couche barrière 108.3. Dans l'exemple de réalisation décrit ici, aucune couche intermédiaire 114 n'est disposée au sein de la première couche barrière 108.1, ni au sein de la dernière couche barrière 108.4.

Ces couches intermédiaires 114 sont fines et ont par exemple chacune une épaisseur comprise entre environ 0,25 nm (une monocouche) et 10 nm, ou bien comprise entre environ 1 nm et 5 nm. Sur l'exemple de la figure 1, chacune des couches intermédiaires 114.1 et 114.2 a une épaisseur égale à environ 2 nm, c'est-à-dire une épaisseur correspondant à environ 8 monocouches du matériau de ces couches intermédiaires 114.

Chacune des couches intermédiaires 114 comporte un semi-conducteur de type III-N dont le gap est supérieur à celui du semi-conducteur de la couche barrière 108 dans laquelle la couche intermédiaire 114 est disposée. Le semi-conducteur des couches intermédiaires 114 peut être du GaN, ou de l'InGaN avec une proportion d'indium par rapport au gallium qui est inférieure à celle de l'InGaN de la couche barrière 108 dans laquelle la couche intermédiaire 114 est disposée. Autrement dit, en considérant une couche barrière 108 comportant de l'In_{Y}Ga_{1-Y}N et une couche intermédiaire 114 disposée au sein de cette couche barrière 108 et qui comporte de l'In_{Z}Ga_{1-Z}N, les proportions d'indium Y et Z sont donc telles que Z < Y.

De manière avantageuse, les concentrations en indium Z et Y sont telles que Z ≤ 0,8^{∗}Y, et cela afin d'avoir une ou plusieurs couches intermédiaires 114 se démarquant nettement des couches barrières 108.

Dans tous les cas, le gap du matériau de la ou des couches intermédiaires 114 est supérieur à celui du matériau de la ou des couches barrières 108 de la LED 100.

Les couches intermédiaires 114 sont réalisées de préférence telles que le pourcentage d'indium dans le matériau des couches intermédiaires 114 soit le plus faible possible. Ainsi, les couches intermédiaires 114 comportent de préférence du GaN.

De manière générale, les couches intermédiaires 114 peuvent comporter de l'Al_{U}In_{Z}Ga_{1-U-Z}N, avec U et Z nombres réels tels que 0 ≤ U + Z ≤ 1 et 0 ≤ Z < Y. Ainsi, le semi-conducteur des couches intermédiaires 114 peut correspondre à de l'AIGaN, de l'AlInGaN, de l'InGaN ou encore du GaN. Il est également possible que les couches intermédiaires 114 comportent du BGaN.

Les couches intermédiaires 114 comportent, comme dans toute la zone active 105, du semi-conducteur intrinsèque, c'est-à-dire non dopé intentionnellement, et peuvent avoir des concentrations en donneurs résiduels comprises entre environ 10¹⁵ et 10²⁰ donneurs/cm³.

La présence des couches intermédiaires 114 au sein de certaines des couches barrières 108 de la LED 100 permet d'augmenter l'efficacité radiative, ou rendement quantique interne, de la LED 100. En effet, en intégrant ces couches intermédiaires 114 dans une partie des couches barrières 108 lors de l'épitaxie mise en œuvre pour former la zone active 105, le cristal d'InGaN obtenu formant cette zone active 105 a une meilleure qualité optique que celui obtenu en l'absence de ces couches intermédiaires 114. En effet, l'insertion de ces couches intermédiaires 114 permet de réduire la rugosité de la surface de croissance lors de l'épitaxie de la zone active 105, ce qui permet d'améliorer la qualité cristalline et l'homogénéité d'épaisseur des puits quantiques réalisés. L'insertion des couches intermédiaires 114 au sein de certaines des couches barrières 108 a également pour effet de modifier la répartition des charges dans les puits quantiques en favorisant les recombinaisons radiatives.

Les différentes simulations décrites ci-dessous pour illustrer les effets obtenus par l'insertion des couches intermédiaires 114 sont réalisées avec un logiciel de type TCAD, par exemple le logiciel de simulation SILVACO® d'ATLAS®.

La figure 2 représente le diagramme de bandes d'énergie (bande de conduction et bande de valence), pour une densité de courant égale à 100 A/cm², d'une LED, appelée LED test, de structure similaire à celle de la LED 100 précédemment décrite mais ne comportant pas les couches intermédiaires 114. La LED test comporte donc un empilement de couches formé, dans cet ordre, des couches 102, 108.1, 106.1, 108.2, 106.2, 108.3, 106.3, 108.4, 112 et 104. Pour simplifier la lecture de ce diagramme, des références similaires à celles utilisées précédemment pour les couches de la LED 100 sont inscrites sur la figure 2 pour indiquer les niveaux d'énergie au sein des différentes couches de la LED test.

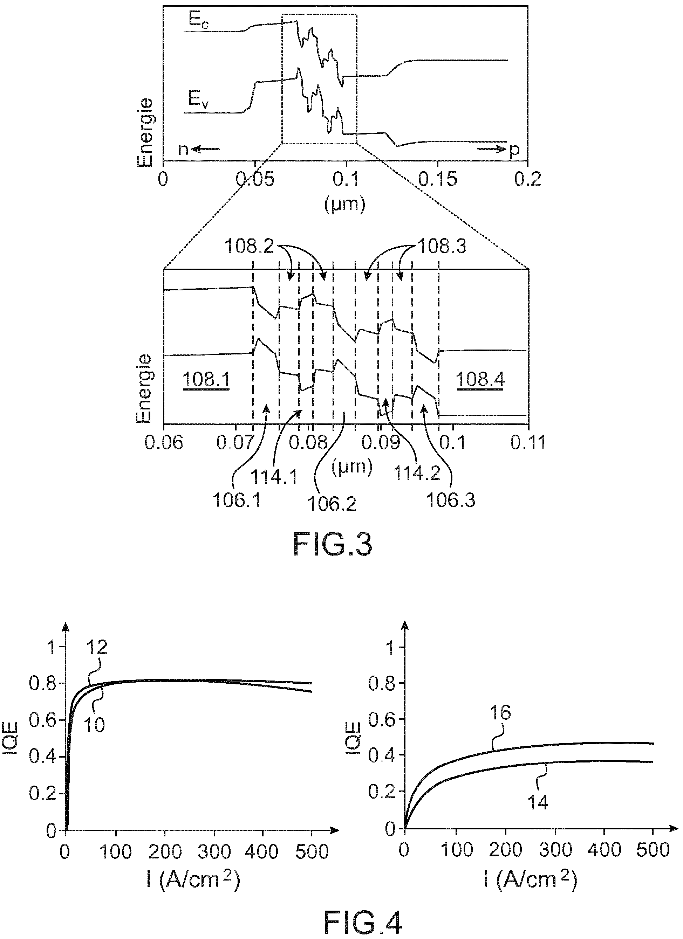

La figure 3 représente le diagramme de bandes d'énergie de la LED 100 qui comporte donc les couches intermédiaires 114.1 et 114.2 comme précédemment décrit en liaison avec la figure 1, pour une densité de courant égale à 100 A/cm².

Sur la figure 4, la courbe 10 représente la valeur de l'efficacité radiative (IQE) pour la LED test ne comportant pas les couches intermédiaires 114 ni la couche de blocage d'électrons 112, et pour une durée de vie Shockley-Read-Hall des porteurs minoritaires τ_{SRH} = 3 ns, cette durée de vie étant représentative de l'efficacité des recombinaisons non-radiatives au sein de la LED (plus la valeur de τ_{SRH} est faible, plus les recombinaisons non-radiatives sont efficaces). La courbe 12 représente la valeur de l'efficacité radiative pour la LED 100 précédemment décrite mais ne comportant pas la couche de blocage d'électrons 112, et pour τ_{SRH} = 3 ns. La courbe 14 représente la valeur de l'efficacité radiative pour la LED test sans les couches intermédiaires 114 ni la couche de blocage d'électrons 112, et pour τ_{SRH} = 0,3 ns. La courbe 16 représente la valeur de l'efficacité radiative pour la LED 100 précédemment décrite mais ne comportant pas la couche de blocage d'électrons 112, et pour τ_{SRH} = 0,3 ns.

Dans la LED 100 et la LED test utilisées pour obtenir les courbes de la figure 4, les couches barrières comportent de l'In_{0,12}Ga_{0,88}N et les couches émissives comportent de l'In_{0,3}Ga_{0,7}N.

Les courbes 10 et 12 montrent que, dans le cas d'une faible efficacité des recombinaisons non radiatives, l'ajout des couches intermédiaires 114 au sein de certaines des couches barrières 108 de la zone active 105 de la LED 100 n'altère pas l'efficacité radiative de la LED 100. Les courbes 14 et 16 montrent que, dans le cas d'une forte efficacité des recombinaisons non radiatives, l'ajout des couches intermédiaires 114 au sein de certaines des couches barrières 108 de la zone active 105 de la LED 100 améliore l'efficacité radiative de la LED 100. Ainsi, pour une densité de courant égale à environ 100 A/cm², l'ajout des couches intermédiaires 114 fait passer l'IQE d'une valeur égale à environ 28 % (courbe 14) à une valeur égale à environ 37 % (courbe 16).

L'effet d'amélioration de l'IQE est amplifié lorsque la durée de vie τ_{SRH} des puits quantiques, associée aux recombinaisons non radiatives, diminue. Or, plus la qualité du cristal est mauvaise, plus les recombinaisons non-radiatives sont nombreuses et plus cette durée de vie τ_{SRH} diminue. L'ajout des couches intermédiaires 114 est donc particulièrement intéressante dans le cas où le cristal formant les couches de la zone active 105 est de mauvaise qualité, ce qui est le cas lorsque la proportion d'indium dans les couches actives 106 est importante, comme par exemple dans le cas d'une LED destinée à réaliser des émissions lumineuses de grandes longueurs d'ondes. Ainsi, en considérant le cas décrit ci-dessus avec τ_{SRH} = 0,3 ns pour la LED test, il est possible de comparer l'IQE obtenu avec celui de la LED 100 à τ_{SRH} = 3 ns car le fait d'ajouter les couches intermédiaires 114 améliore la qualité du cristal obtenu, et par conséquent augmente la valeur de τ_{SRH}. L'amélioration de l'efficacité radiative de la LED engendrée par l'ajout des couches intermédiaires 114 est donc bien plus importante que le gain de 9 % cité précédemment (IQE passant d'environ 28 % à environ 37 % entre les courbes 14 et 16). Ainsi, pour une densité de courant égale à environ 100 A/cm², la valeur de l'IQE passe d'environ 28 % à près de 80 % grâce notamment à l'ajout des couches intermédiaires 114.

L'amélioration de l'IQE engendrée par l'ajout des couches intermédiaires 114 s'explique par une modification de la répartition des porteurs de charges dans la zone active 105. En effet, l'utilisation d'InGaN à la place du GaN pour réaliser les couches barrières 108 a pour effet d'abaisser les barrières de potentiel formées par ces couches barrières 108, permettant aux trous dont la mobilité est plus faible d'atteindre plus facilement les puits quantiques du côté n de la LED 100, c'est-à-dire du côté de la première couche 102 dans l'exemple précédemment décrit en liaison avec la figure 1. Cette répartition plus homogène des trous entre les différents puits quantiques de la zone active tend néanmoins à réduire le nombre de trous dans le puits quantique le plus proche du coté p de la LED, c'est-à-dire du côté de la deuxième couche 104 dans l'exemple précédent et qui correspond au puits quantique formé par la troisième couche émissive 106.3 et qui est le plus peuplé par les électrons et les trous et celui dans lequel les recombinaisons radiatives sont les plus importantes. L'ajout des couches intermédiaires 114 en aval du courant des trous, c'est-à-dire dans les couches barrières 108.2 et 108.3 dans l'exemple précédemment décrit, permet de créer une barrière de potentiel pour garder les trous qui se trouvent dans le puits quantique disposé le plus près de la deuxième couche 104 dopée p et donc d'y augmenter le nombre total de trous. L'IQE de la LED 100 est donc amélioré par rapport à celui de la LED test grâce à la présence des couches intermédiaires 114 car la probabilité des recombinaisons radiatives pouvant se produire augmente pour un nombre total de porteurs injectés qui reste le même.

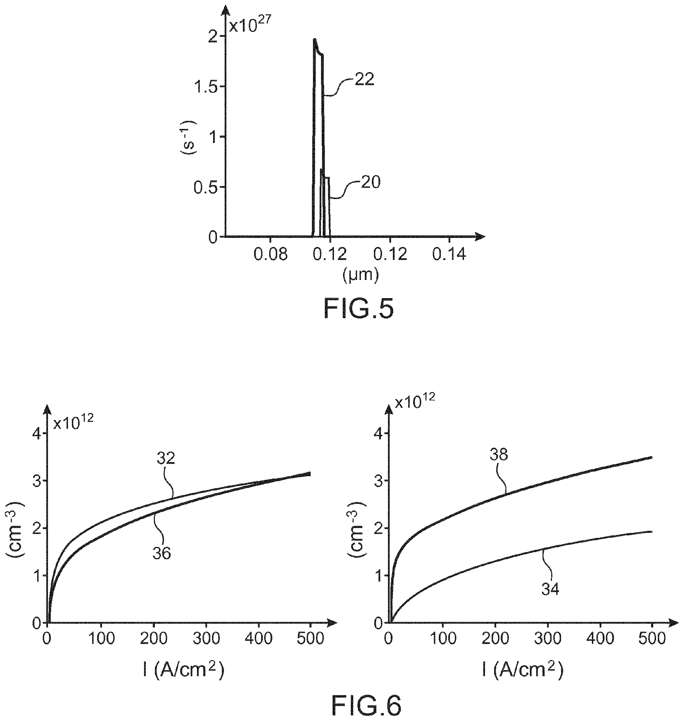

La courbe 20 de la figure 5 représente le taux de recombinaisons radiatives obtenu pour la LED test, et la courbe 22 représente le taux de recombinaisons radiatives obtenu pour la LED 100. Ces courbes 20 et 22 sont obtenues pour une densité de courant égale à environ 100 A/cm², une durée de vie τ_{SRH} = 0,3 ns, et en l'absence de couche de blocage d'électrons dans la LED test et dans la LED 100. Ces deux courbes 20 et 22 montrent bien la forte augmentation des recombinaisons radiatives se produisant dans la couche émissive 106.3 la plus proche de la deuxième couche 104 dopée p (les recombinaisons radiatives dans les deux autres puits sont bien moins nombreuses et ne sont pas visibles sur la figure 5).

Les courbes 32 et 34 de la figure 6 représentent respectivement les concentrations d'électrons et de trous dans la troisième couche émissive 106.3 de la LED test. Les courbes 36 et 38 de la figure 6 représentent respectivement les concentrations d'électrons et de trous obtenues dans la troisième couche émissive 106.3 de la LED 100. Ces valeurs sont obtenues en l'absence de couche de blocage d'électrons dans la LED test et dans la LED 100, et pour une durée de vie τ_{SRH} = 0,3 ns. En considérant une densité de courant égale à environ 100 A/cm², les courbes 32 à 38 de la figure 6 montrent que l'ajout des couches intermédiaires 114 engendre, dans le troisième puits quantique comportant la troisième couche émissive 106.3, une perte d'environ 13 % d'électrons et un gain d'environ 58 % de trous. L'ajout des couches intermédiaires 114 permet donc d'obtenir une configuration plus favorable pour obtenir plus de recombinaisons radiatives (augmentation du produit des porteurs) dans ce dernier puits quantique présent du côté de la couche dopée p, et donc d'améliorer l'IQE de la LED.

Dans le mode de réalisation particulier de la LED 100 précédemment décrit en liaison avec la figure 1, chacune des couches intermédiaires 114 est disposée au sein d'une couche barrière 108 séparant deux couches émissives 106 voisines.

Selon une première variante, il est possible qu'une seule couche intermédiaire 114 soit présente dans la zone active 105. Dans ce cas, cette unique couche intermédiaire 114 est disposée dans la couche barrière séparant la dernière couche émissive, c'est-à-dire celle la plus proche de la deuxième couche 104 dopée p, et la couche émissive voisine de cette dernière couche émissive. Selon cette première variante, l'unique couche intermédiaire 114 présente dans la zone active 105 correspond à la couche intermédiaire 114.2 présente dans la couche barrière 108.3.

Selon une deuxième variante, il est possible qu'une couche intermédiaire 114 soit disposée au sein de chacune des couches barrières 108 sauf celle qui est la plus proche de la deuxième couche 104 dopée p (qui correspond à la couche barrière 108.4 sur l'exemple de la figure 1). Selon cette deuxième variante, le LED 100 comporterait alors, en plus des couches intermédiaires 114.1 et 114.2, une troisième couche intermédiaire 114 qui serait disposée au sein de la première couche barrière 108.1.

En outre, dans tous les modes de réalisation et variantes décrites précédemment, il est également possible d'inclure une ou plusieurs couches intermédiaires 114 au sein de la première couche 102. Comme précédemment, le semi-conducteur de cette ou ces couches intermédiaires 114 a un gap supérieur à celui du semi-conducteur de la première couche 102.

Quel que soit le nombre de couches intermédiaires 114 disposées au sein de la zone active 105, aucune couche intermédiaire 114 n'est présente dans la dernière couche barrière qui correspond à celle qui est la plus proche de la deuxième couche 104 dopée p, et cela afin de ne pas empêcher les trous d'atteindre la couche émissive disposée contre cette dernière couche barrière.

Dans le mode de réalisation particulier et les variantes précédemment décrits, une seule couche intermédiaire 114 est disposée dans une couche barrière 108. En variante, il est possible que plusieurs couches intermédiaires 114 soient disposées au sein d'une même couche barrière 108.

Selon une autre variante, il est possible que la LED 100 comporte un seul puits quantique formé par une seule couche émissive 106 disposée entre deux couches barrières 108. Dans ce cas, au moins une couche intermédiaire 114 est disposée dans la couche barrière se trouvant entre la couche émissive 106 et la première couche 102. Dans une telle configuration, cette ou ces couches intermédiaires permettent également d'améliorer l'efficacité radiative de la LED via l'amélioration de la qualité cristalline de la zone active engendrée par la présence de cette ou ces couches intermédiaires 114, et également via un meilleur blocage des trous dans le puits quantique, augmentant ainsi le produit des porteurs, et donc le nombre de recombinaisons radiatives, dans ce puits.

Dans les exemples de réalisation et variantes décrits ci-dessus, lorsque la ou les couches intermédiaires 114 comportent de l'AlInGaN, la composition en indium dans le matériau de la ou des couches intermédiaires est sensiblement constante au sein de cette ou chacune de ces couches. En variante, il est possible que la composition en indium, appelée par exemple Z pour de l'Al_{U}In_{Z}Ga_{1-U-Z}N, de la couche intermédiaire 114 ou, lorsque la LED 100 comporte plusieurs couches intermédiaires 114, d'une ou plusieurs des couches intermédiaires 114, varie entre une première valeur minimale Z₁, nulle ou positive, et une deuxième valeur maximale Z₂ supérieure à Z₁, selon une direction sensiblement perpendiculaire à des faces de la couche intermédiaire 114 en contact avec la couche barrière 108 dans laquelle est disposée la couche intermédiaire 114 (c'est-à-dire parallèlement à l'axe Z). Cette direction peut notamment aller dans le sens allant de la première couche 102 à la deuxième couche 104, c'est-à-dire telle que la partie de la couche intermédiaire 114 de plus faible concentration d'indium (Z₁) se trouve du côté de la première couche 102, ou dans le sens allant de la deuxième couche 104 à la première couche 102. La concentration en indium maximale Z₂ est inférieure à celle de la couche barrière 108 dans laquelle la couche intermédiaire 114 est disposée. En considérant que la couche barrière 108 dans laquelle est disposée une telle couche intermédiaire 114 comporte de l'In_{Y}Ga_{1-Y}N, la valeur Z₂ est avantageusement telle que Z₂ ≤ 0,8^{∗}Y. Lorsque la LED 100 comporte plusieurs couches intermédiaires 114, cette concentration en indium variable de l'InGaN des couches intermédiaires 114 peut être la même d'une couche intermédiaire 114 à l'autre, ou bien peut être différente d'une couche intermédiaire 114 à l'autre (les valeurs Z₁ et Z₂ étant dans ce cas différentes d'une couche intermédiaire 114 à l'autre).

Dans les exemples de réalisation et variantes décrits ci-dessus, la composition en indium dans le matériau de la ou des couches barrières est sensiblement constante au sein de cette ou chacune de ces couches. En variante, il est possible que la composition en indium, appelée par exemple Y pour de l'In_{Y}Ga_{1-Y}N, d'une ou plusieurs des couches barrières 108 varie entre une première valeur minimale Y₁ et une deuxième valeur maximale Y₂ supérieure à Y₁, selon la direction dans laquelle les différentes couches de la LED 100 sont empilées (c'est-à-dire parallèlement à l'axe Z). La partie de la couche barrière 108 de plus faible concentration d'indium (Y₁) peut se trouver de préférence du côté de la première couche 102, ou bien du côté de la deuxième couche 104. Dans le cas d'une couche barrière 108 ayant une telle concentration en indium variable et dans laquelle sont disposées une ou plusieurs couches intermédiaires 114, la concentration en indium minimale Y₁ est supérieure à celle ou celles de la ou de ces couches intermédiaires 114 , c'est-à-dire telle que 0 ≤ Z < Y₁.

Les deux variantes exposées ci-dessus peuvent être combinées, c'est-à-dire qu'une ou plusieurs couches intermédiaires 114 peuvent avoir une concentration en indium variant le long de leur épaisseur et être disposées au sein d'une ou plusieurs couches barrières 108 ayant une concentration en indium variant le long de leur épaisseur. Dans ce cas, ces concentrations variables sont telles que Z₂ < Y₁.

Selon une autre variante, la LED 100 peut comporter une couche tampon d'InGaN dopé n, disposée entre la première couche 102 et la zone active 105. Une telle couche tampon peut correspondre à celle décrite dans le document WO 2014/154690 A1. À partir de la structure de la LED 100 telle que représentée sur la figure 1, des électrodes sont ensuite réalisées telles qu'elles soient reliées électriquement aux première et deuxième couches 102, 104. Ainsi, une première électrode peut être réalisée en gravant une partie des couches 104, 112, 105 et 102 pour que la première électrode puisse être en contact électriquement avec la première couche 102 au niveau d'une face latérale de cette première couche 102. De manière alternative, la première électrode peut être réalisée en supprimant la couche 110 et en formant la première électrode contre la face inférieure de la première couche 102. Dans tous les cas, la deuxième électrode peut être réalisée contre la face supérieure de la deuxième couche 104.

La LED 100 précédemment décrite, comportant une zone active formée d'une alternance de puits quantiques et de couches barrières, et une ou plusieurs couches intermédiaires, peut être réalisée sous la forme d'une diode planaire, c'est-à-dire sous la forme d'un empilement de couches formées sur un substrat, comme représenté sur la figure 1, les faces principales des différentes couches étant disposées parallèlement au plan du substrat (parallèle au plan (X,Y)). En variante, la LED 100 peut également être réalisée sous la forme d'un nanofil, axial ou radial, comme décrit par exemple dans le document WO 2014/154690 A1.

## Revendications

1. Diode électroluminescente (100) comprenant au moins :
- une première couche (102) comprenant du semi-conducteur dopé n et une deuxième couche (104) comprenant du semi-conducteur dopé p, les première et deuxième couches (102, 104) formant une jonction p-n ;
- une zone active (105) disposée entre les première et deuxième couches (102, 104), comprenant au moins une couche émissive (106.2) comportant de l'In_{X}Ga_{1-X}N et apte à former un puits quantique, et au moins deux couches barrières (108.2, 108.3) comportant de l'In_{Y}Ga_{1-Y}N et entre lesquelles la couche émissive (106.2) est disposée, et avec X et Y nombres réels tels que 0 < Y < X ;
- une couche intermédiaire (114.1), disposée dans la couche barrière (108.2) se trouvant entre la couche émissive (106.2) et la première couche (102) telle que des parties de ladite couche barrière (108.2) soient disposées de part et d'autre de la couche intermédiaire (114.1), ou disposée entre ladite couche barrière (108.2) et la couche émissive (106.2), la couche intermédiaire (114.1) comportant un semi-conducteur de type III-N dont le gap est supérieur à celui du semi-conducteur de ladite couche barrière (108.2) ;
et dans laquelle :
- la deuxième couche (104) comporte du GaN et la première couche (102) comporte de l'In_{V}Ga_{1-V}N, avec V nombre réel tel que 0 < V ; ou
- la deuxième couche (104) comporte de l'In_{W}Ga_{1-W}N et la première couche (102) comporte de l'In_{V}Ga_{1-V}N, avec V et W nombres réels tels que 0 < W < Y et 0< W < V.

2. Diode électroluminescente (100) selon la revendication 1, comportant en outre un substrat de croissance (110) comportant de l'InGaN sur lequel la première couche (102) est disposée, et dans laquelle la première couche (102) comporte de l'In_{V}Ga_{1-V}N, avec 0 < V, et la deuxième couche (104) comporte de l'In_{W}Ga_{1-W}N, avec 0 < W.

3. Diode électroluminescente (100) selon l'une des revendications précédentes, dans laquelle l'épaisseur de la couche intermédiaire (114.1) est comprise entre 0,25 nm et 10 nm.

4. Diode électroluminescente (100) selon l'une des revendications précédentes, dans laquelle le semi-conducteur de la couche intermédiaire (114.1) comporte de l'Al_{U}In_{Z}Ga_{1-U-Z}N, avec U et Z nombres réels tels que 0 ≤ U + Z ≤ 1 et 0 ≤ Z < Y, ou comporte du BGaN.

5. Diode électroluminescente (100) selon la revendication 4, dans laquelle, lorsque le semi-conducteur de la couche intermédiaire (114.1) comporte de l'Al_{U}In_{Z}Ga_{1-U-Z}N, les concentrations en indium Z et Y dans les semi-conducteurs de la couche intermédiaire (114.1) et de la couche barrière (108.2) dans laquelle la couche intermédiaire (114.1) est disposée sont telles que Z ≤ 0,8^{∗}Y.

6. Diode électroluminescente (100) selon l'une des revendications 4 ou 5, dans laquelle, lorsque le semi-conducteur de la couche intermédiaire (114.1) comporte de l'Al_{U}In_{Z}Ga_{1-U-Z}N, la concentration en indium Z dans le semi-conducteur de la couche intermédiaire (114.1) varie entre une première valeur minimale Z₁ et une deuxième valeur maximale Z₂ supérieure à Z₁ selon une direction sensiblement perpendiculaire à des faces de la couche intermédiaire (114.1) en contact avec la couche barrière (108.2) dans laquelle est disposée la couche intermédiaire (114.1), et dans laquelle 0 ≤ Z₁ < Z₂ < Y.

7. Diode électroluminescente (100) selon l'une des revendications précédentes, dans laquelle la concentration en indium Y dans le semi-conducteur d'au moins la couche barrière (108.2) dans laquelle la couche intermédiaire (114.1) est disposée varie entre une première valeur minimale Y₁ et une deuxième valeur maximale Y₂ supérieure à Y₁ selon une direction sensiblement perpendiculaire aux faces de la couche barrière (108.2) en contact avec la couche intermédiaire (114.1), et dans laquelle 0 ≤ Y₁ < Y₂ < X.

8. Diode électroluminescente (100) selon l'une des revendications précédentes, dans laquelle :
- la zone active (105) comporte plusieurs couches émissives (106.1, 106.2, 106.3) comprenant de l'InGaN et chacune apte à former un puits quantique, et plusieurs couches barrières (108.1, 108.2, 108.3, 108.4) comprenant de l'InGaN et telles que chaque couche émissive (106.1, 106.2, 106.3) soit disposée entre deux couches barrières (108.1, 108.2, 108.3, 108.4) qui sont en contact avec ladite couche émissive (106.1, 106.2, 106.3) au niveau de deux faces opposées de ladite couche émissive,
- la couche intermédiaire (114.1) est disposée dans l'une (108.2) des couches barrières (108.1, 108.2, 108.3, 108.4) se trouvant entre l'une (106.2) des couches émissives (106.1, 106.2, 106.3) et la première couche (102) telle que des parties de ladite une (108.2) des couches barrières (108.1, 108.2, 108.3, 108.4) soient disposées de part et d'autre de la couche intermédiaire (114.1), ou disposée entre ladite une (108.2) des couches barrières (108.1, 108.2, 108.3, 108.4) et ladite une (106.2) des couches émissives (106.1, 106.2, 106.3),
- le gap du semi-conducteur de la couche intermédiaire (114.1) est supérieur à celui du semi-conducteur des couches barrières (108.1, 108.2, 108.3, 108.4) et les concentrations en indium dans l'InGaN des couches émissives (106.1, 106.2, 106.3) sont supérieures à celles dans l'InGaN des couches barrières (108.1, 108.2, 108.3, 108.4).

9. Diode électroluminescente (100) selon la revendication 8, comportant plusieurs couches intermédiaires (114.1, 114.2) telles qu'une ou plusieurs desdites couches intermédiaires (114.1, 114.2) soient disposées dans une ou plusieurs des couches barrières (108.1, 108.2, 108.3, 108.4) se trouvant entre l'une des couches émissives (106.1, 106.2, 106.3) et la première couche (102), des parties de ladite une ou plusieurs des couches barrières (108.1, 108.2, 108.3, 108.4) étant disposées de part et d'autre de chacune des couches intermédiaires (114.1, 114.2).

10. Diode électroluminescente (100) selon l'une des revendications 8 ou 9, dans laquelle les concentrations en indium dans l'InGaN des couches émissives (106.1, 106.2, 106.3) sont sensiblement égales les unes par rapport aux autres.

11. Diode électroluminescente (100) selon l'une des revendications précédentes, comportant en outre une couche tampon de semi-conducteur dopé n disposée entre la première couche (102) et la zone active (105), ledit semi-conducteur dopé n de la couche tampon comportant une énergie de bande interdite inférieure ou égale à 97 % de l'énergie de bande interdite du semi-conducteur dopé p de la deuxième couche (104).

12. Diode électroluminescente (100) selon l'une des revendications précédentes, comportant en outre une couche de blocage d'électrons (112) comprenant au moins un semi-conducteur dopé p de type III-N dont le gap est supérieur à celui du semi-conducteur de la deuxième couche (104) et disposée entre la deuxième couche (104) et la zone active (105).

## Patentansprüche

1. Elektrolumineszenzdiode (100), umfassend wenigstens Folgendes:
- eine erste Schicht (102), umfassend einen n-dotierten Halbleiter, und eine zweite Schicht (104), umfassend einen p-dotierten Halbleiter, wobei die erste und die zweite Schicht (102, 104) einen p-n-Übergang bilden;
- eine aktive Zone (105), die zwischen der ersten und der zweiten Schicht (102, 104) angeordnet ist, umfassend wenigstens eine Emissionsschicht (106.2), die In_{X}Ga_{1-X}N umfasst und dazu ausgelegt ist, einen Quantentopf zu bilden, sowie wenigstens zwei Barriereschichten (108.2, 108.3), die In_{Y}Ga_{1-Y}N umfassen, und zwischen denen die Emissionsschicht (106.2) angeordnet ist, und wobei X und Y reelle Zahlen derart sind, dass 0 < Y < X;
- eine Zwischenschicht (114.1), die in der Barriereschicht (108.2) angeordnet ist, die sich zwischen der Emissionsschicht (106.2) und der ersten Schicht (102) befindet, derart, dass Teile der Barriereschicht (108.2) auf beiden Seiten der Zwischenschicht (114.1) angeordnet sind, oder zwischen der Barriereschicht (108.2) und der Emissionsschicht (106.2) angeordnet sind, wobei die Zwischenschicht (114.1) einen Halbleiter vom Typ III-N umfasst, dessen Lücke größer ist als jene des Halbleiters der Barriereschicht (108.2);
und bei der:
- die zweite Schicht (104) GaN umfasst, und die erste Schicht (102) In_{V}Ga_{1-V}N umfasst, wobei V eine reelle Zahl derart ist, dass 0 < V; oder
- die zweite Schicht (104) In_{W}Ga_{1-W}N umfasst und die erste Schicht (102) In_{V}Ga_{1-V}N umfasst, wobei V und W reelle Zahlen derart sind, dass 0 < W < Y und 0 < W < V.

2. Elektrolumineszenzdiode (100) nach Anspruch 1, ferner umfassend ein Wachstumssubstrat (110), das InGaN umfasst, auf dem die erste Schicht (102) angeordnet ist, und wobei die erste Schicht (102) In_{V}Ga_{1-V}N mit 0 < V umfasst, und die zweite Schicht (104) In_{W}Ga_{1-W}N mit 0 < W umfasst.

3. Elektrolumineszenzdiode (100) nach einem der vorhergehenden Ansprüche, bei der die Dicke der Zwischenschicht (114.1) zwischen 0,25 nm und 10 nm enthalten ist.

4. Elektrolumineszenzdiode (100) nach einem der vorhergehenden Ansprüche, bei der der Halbleiter der Zwischenschicht (114.1) Al_{U}In_{Z}Ga_{1-U-Z}N umfasst, wobei U und Z reelle Zahlen derart sind, dass 0 ≤ U + Z ≤ 1 und 0 ≤ Z < Y, oder BGaN umfasst.

5. Elektrolumineszenzdiode (100) nach Anspruch 4, bei der dann, wenn der Halbleiter der Zwischenschicht (114.1) Al_{U}In_{Z}Ga_{1-U-Z}N umfasst, die Indiumkonzentrationen Z und Y in den Halbleitern der Zwischenschicht (114.1) und der Barriereschicht (108.2), in der die Zwischenschicht (114.1) angeordnet ist, derart sind, dass Z ≤ 0,8^{∗}Y.

6. Elektrolumineszenzdiode (100) nach einem der Ansprüche 4 oder 5, bei der dann, wenn der Halbleiter der Zwischenschicht (114.1) Al_{U}In_{Z}Ga_{1-U-Z}N umfasst, die Indiumkonzentration Z in dem Halbleiter der Zwischenschicht (114.1) variiert zwischen einem ersten minimalen Wert Z₁ und einem zweiten maximalen Wert Z₂ größer als Z₁ entlang einer Richtung im Wesentlichen orthogonal zu Flächen der Zwischenschicht (114.1) in Kontakt mit der Barriereschicht (108.2), in der die Zwischenschicht (114.1) angeordnet ist, und wobei 0 ≤ Z₁ < Z₂ < Y.

7. Elektrolumineszenzdiode (100) nach einem der vorhergehenden Ansprüche, bei der die Indiumkonzentration Y in dem Halbleiter wenigstens der Barriereschicht (108.2), in der die Zwischenschicht (114.1) angeordnet ist, variiert zwischen einem ersten minimalen Wert Y₁ und einem zweiten maximalen Wert Y₂ größer als Y₁ entlang einer Richtung im Wesentlichen orthogonal zu den Flächen der Barriereschicht (108.2) in Kontakt mit der Zwischenschicht (114.1), und wobei 0 ≤ Y₁ < Y₂ < X.

8. Elektrolumineszenzdiode (100) nach einem der vorhergehenden Ansprüche, bei der:
- die aktive Zone (105) mehrere Emissionsschichten (106.1, 106.2, 106.3) umfasst, die InGaN umfassen und jeweils dazu ausgelegt sind, einen Quantentopf zu bilden, sowie mehrere Barriereschichten (108.1, 108.2, 108.3, 108.4), die InGaN umfassen und derart, dass jede Emissionsschicht (106.1, 106.2, 106.3) angeordnet ist zwischen zwei Barriereschichten (108.1, 108.2, 108.3, 108.4), die in Kontakt sind mit der Emissionsschicht (106.1, 106.2, 106.3) im Bereich von zwei entgegengesetzten Flächen der Emissionsschicht,
- die Zwischenschicht (114.1) in der einen (108.2) von den Barriereschichten (108.1, 108.2, 108.3, 108.4) angeordnet ist, die sich zwischen der einen (106.2) der Emissionsschichten (106.1, 106.2, 106.3) und der ersten Schicht (102) befindet, derart, dass Teile der einen (108.2) von den Barriereschichten (108.1, 108.2, 108.3, 108.4) auf beiden Seiten der Zwischenschicht (114.1) angeordnet sind, oder zwischen der einen (108.2) von den Barriereschichten (108.1, 108.2, 108.3, 108.4) und der einen (106.2) von den Emissionsschichten (106.1, 106.2, 106.3) angeordnet ist,
- die Lücke des Halbleiters der Zwischenschicht (114.1) größer ist als jene des Halbleiters der Barriereschichten (108.1, 108.2, 108.3, 108.4), und die Indiumkonzentrationen in dem InGaN der Emissionsschichten (106.1, 106.2, 106.3) größer sind als jene in dem InGaN der Barriereschichten (108.1, 108.2, 108.3, 108.4).

9. Elektrolumineszenzdiode (100) nach Anspruch 8, umfassend mehrere Zwischenschichten (114.1, 114.2) derart, dass eine oder mehrere der Zwischenschichten (114.1, 114.2) in einer oder mehreren der Barriereschichten (108.1, 108.2, 108.3, 108.4) angeordnet sind, die sich zwischen der einen der Emissionsschichten (106.1, 106.2, 106.3) und der ersten Schicht (102) befinden, wobei Teile der einen oder mehreren Barriereschichten (108.1, 108.2, 108.3, 108.4) auf beiden Seiten von jeder der Zwischenschichten (114.1, 114.2) angeordnet sind.

10. Elektrolumineszenzdiode (100) nach einem der Ansprüche 8 oder 9, bei der die Indiumkonzentrationen in dem InGaN der Emissionsschichten (106.1, 106.2, 106.3) im Wesentlichen zueinander gleich sind.

11. Elektrolumineszenzdiode (100) nach einem der vorhergehenden Ansprüche, ferner umfassend eine Pufferschicht aus n-dotiertem Haltleiter, die zwischen der ersten Schicht (102) und der aktiven Zone (105) angeordnet ist, wobei der n-dotierte Halbleiter der Pufferschicht eine Energie des verbotenen Bands kleiner oder gleich 97 % der Energie des verbotenen Bands des p-dotierten Halbleiters der zweiten Schicht (104) hat.

12. Elektrolumineszenzdiode (100) nach einem der vorhergehenden Ansprüche, ferner umfassend eine Elektronensperrschicht (112), umfassend wenigstens einen p-dotierten Halbleiter vom Typ III-N, dessen Lücke größer ist als jene des Halbleiters der zweiten Schicht (104), und die zwischen der zweiten Schicht (104) und der aktiven Zone (105) angeordnet ist.

## Claims

1. A light emitting diode (100) comprising at least:
- a first layer (102) comprising an n-doped semiconductor and a second layer (104) comprising a p-doped semiconductor, the first and second layers (102, 104) forming a p-n junction;
- an active zone (105) disposed between the first and second layers (102, 104), comprising at least one emissive layer (106.2) including In_{X}Ga_{1-X}N and configured to form a quantum well, and at least two barrier layers (108.2, 108.3) including In_{Y}Ga_{1-Y}N and between which the emissive layer (106.2) is disposed, with X and Y being real numbers such that 0 < Y < X;
- an intermediate layer (114.1), disposed in the barrier layer (108.2) lying between the emissive layer (106.2) and the first layer (102) such that parts of said barrier layer (108.2) are disposed on either side of the intermediate layer (114.1), or disposed between said barrier layer (108.2) and the emissive layer (106.2), the intermediate layer (114.1) including a III-N type semiconductor the band gap of which is higher than that of the semiconductor of said barrier layer (108.2);
and in which:
- the second layer (104) includes GaN and the first layer (102) includes In_{V}Ga_{1-V}N, with V being a real number such that 0 < V; or
- the second layer (104) includes In_{W}Ga_{1-W}N and the first layer (102) includes In_{V}Ga_{1-V}N, with V and W being real numbers such that 0 < W < Y and 0 < W < V.

2. The light emitting diode (100) according to claim 1, further including a growth substrate (110) including InGaN on which the first layer (102) is disposed, and wherein the first layer (102) includes In_{V}Ga_{1-V}N, with 0 < V, and the second layer (104) includes In_{W}Ga_{1-W}N, with 0 < W.

3. The light emitting diode (100) according to one of the preceding claims, wherein the thickness of the intermediate layer (114.1) is between about 0.25 nm and 10 nm.

4. The light emitting diode (100) according to one of the preceding claims, wherein the semiconductor of the intermediate layer (114.1) includes Al_{U}In_{Z}Ga_{1-U-Z}N, with U and Z being real numbers such that 0 ≤ U + Z ≤ 1 and 0 ≤ Z < Y, or includes BGaN.

5. The light emitting diode (100) according to claim 4, wherein, when the semiconductor of the intermediate layer (114.1) includes Al_{U}In_{Z}Ga_{1-U-Z}N, the concentrations of indium Z and Y in the semiconductors of the intermediate layer (114.1) and of the barrier layer (108.2) in which the intermediate layer (114.1) is disposed are such that Z ≤ 0.8^{∗}Y.

6. The light emitting diode (100) according to one of claims 4 and 5, wherein, when the semiconductor of the intermediate layer (114.1) includes Al_{U}In_{Z}Ga_{1-U-Z}N, the concentration of indium Z in the semiconductor of the intermediate layer (114.1) varies between a first minimum value Z₁ and a second maximum value Z₂ higher than Z₁ along a direction substantially perpendicular to faces of the intermediate layer (114.1) in contact with the barrier layer (108.2) in which the intermediate layer (114.1) is disposed, and wherein 0 ≤ Z₁ < Z₂ < Y.

7. The light emitting diode (100) according to one of the preceding claims, wherein the concentration of indium Y in the semiconductor of at least the barrier layer (108.2) in which the intermediate layer (114.1) is disposed varies between a first minimum value Y₁ and a second maximum value Y₂ higher than Y₁ along a direction substantially perpendicular to the faces of the barrier layer (108.2) in contact with the intermediate layer (114.1), and wherein 0 ≤ Y₁ < Y₂ < X.

8. The light emitting diode (100) according to one of the preceding claims, wherein:
- the active zone (105) includes several emissive layers (106.1, 106.2, 106.3) comprising InGaN and each able to form a quantum well, and several barrier layers (108.1, 108.2, 108.3, 108.4) comprising InGaN and such that each emissive layer (106.1, 106.2, 106.3) is disposed between two barrier layers (108.1, 108.2, 108.3, 108.4) which are in contact with said emissive layer (106.1, 106.2, 106.3) at two opposite faces of said emissive layer,
- the intermediate layer (114.1) is disposed in one (108.2) of the barrier layers (108.1, 108.2, 108.3, 108.4) lying between one (106.2) of the emissive layers (106.1, 106.2, 106.3) and the first layer (102) such that parts of said one (108.2) of the barrier layers (108.1, 108.2, 108.3, 108.4) are disposed on either side of the intermediate layer (114.1), or disposed between said one (108.2) of the barrier layers (108.1, 108.2, 108.3, 108.4) and said one (106.2) of the emissive layers (106.1, 106.2, 106.3),
- the band gap of the semiconductor of the intermediate layer (114.1) is higher than that of the semiconductor of the barrier layers (108.1, 108.2, 108.3, 108.4) and the concentrations of indium in InGaN of the emissive layers (106.1, 106.2, 106.3) are higher than those in InGaN of the barrier layers (108.1, 108.2, 108.3, 108.4).

9. The light emitting diode (100) according to claim 8, including several intermediate layers (114.1, 114.2) such that one or more of said intermediate layers (114.1, 114.2) are disposed in one or more of the barrier layers (108.1, 108.2, 108.3, 108.4) lying between one of the emissive layers (106.1, 106.2, 106.3) and the first layer (102), parts of said one or more of the barrier layers (108.1, 108.2, 108.3, 108.4) being disposed on either side of each of the intermediate layers (114.1, 114.2).

10. The light emitting diode (100) according to one of claims 8 and 9, wherein the concentrations of indium in InGaN of the emissive layers (106.1, 106.2, 106.3) are substantially equal to each other.

11. The light emitting diode (100) according to one of the preceding claims, further including a buffer layer of n-doped semiconductor disposed between the first layer (102) and the active zone (105), said n-doped semiconductor of the buffer layer including a band gap energy lower than or equal to about 97 % of the band gap energy of the p-doped semiconductor of the second layer (104).

12. The light emitting diode (100) according to one of the preceding claims, further including an electron blocking layer (112) comprising at least one III-N type p-doped semiconductor the band gap of which is higher than that of the semiconductor of the second layer (104) and disposed between the second layer (104) and the active zone (105).
